# EUROPÄISCHE PATENTSCHRIFT

(11) **EP 3 084 296 B1**
(45) Veröffentlichungstag und Bekanntmachung des Hinweises auf die Patenterteilung: **01.11.2017**
(21) Anmeldenummer: 14827714.8
(22) Anmeldetag: 16.12.2014
(51) Int. Cl.: F21V 19/04, H01L 25/04, H01L 27/32, F21Y 105/00, F21Y 115/15

(54) **LEUCHTE ODER DISPLAY UMFASSEND WENIGSTENS EIN LICHT-PANEL AUF EINER TRÄGERPLATTE**
LAMP OR DISPLAY COMPRISING AT LEAST ONE LIGHT PANEL ON A CARRIER PLATE
LAMPE OU DISPOSITIF D'AFFICHAGE COMPRENANT AU MOINS UN PANNEAU LUMINEUX SUR UNE PLAQUE DE SUPPORT

(30) Priorität: 16.12.2013 DE 102013114115; 14.05.2014 DE 102014106760
(43) Veröffentlichungstag der Anmeldung: 26.10.2016
(73) Patentinhaber: emdedesign GmbH, 60389 Frankfurt (DE)
(72) Erfinder: EMDE, Thomas, 60389 Frankfurt am Main (DE); PETERSEN, Christoph, 35423 Lich (DE); MEIER,Jonathan, 60313 Frankfurt am Main (DE); IRLBACHER, Günther, 92539 Schönsee (DE); STOPPA, Alexander, 92539 Schönsee (DE)
(74) Vertreter: Fritz, Edmund Lothar
(86) Internationale Anmeldenummer: PCT/DE2014/100448
(87) Internationale Veröffentlichungsnummer: WO 2015/090279

(56) Entgegenhaltungen:
- WO-A1-2013/017372
- DE-U1-202009 016 123

## Beschreibung

Die vorliegende Erfindung betrifft eine Leuchte oder ein Display umfassend wenigstens ein flächig auf einer mindestens teilweise lichtdurchlässigen Trägerplatte der Leuchte aufliegendes oder an dieser anliegendes Licht-Panel in Form eines OLED-Leuchtmittels.

Licht-Panels im Sinne der vorgenannten Definition umfassen Licht abgebende OLED-Panels, die in Beleuchtungseinrichtungen eingesetzt werden können (OLED-Licht-Panels), als auch OLED-Display-Panels, d.h. OLED-Panels, welche eine Displayfunktion haben und geeignet sind, stehende Bilder (Fotos, Werbung etc.) oder bewegte Bilder (Filme, Videos etc.) wiederzugeben.

Organische LEDs, hierin nachfolgend als OLED bezeichnet sind bereits seit einigen Jahren bekannt und wurden bislang vorwiegend im Display-Bereich eingesetzt. Der Grund hierfür liegt darin, dass der von den OLEDs abgegebene Lichtstrom bis vor einiger Zeit für Zwecke der Allgemeinbeleuchtung nicht ausreichend war. OLED ließen sich daher lediglich für eine ergänzende Beleuchtung oder Effektbeleuchtung einsetzen. Zudem waren lagen die Herstellkosten der OLEDs bis vor einigen Jahren so hoch, dass ein Einsatz für Zwecke der Allgemeinbeleuchtung nicht wirtschaftlich war. In jüngster Zeit wurden jedoch immer effektivere OLEDs mit steigender Lichtausbeute entwickelt und die Produktionskosten sind stetig gesunken.

Beispielsweise bietet die Fa. Philips unter der Bezeichnung "lumiblade GL 350" flache OLED-Panels an, die bei einer Größe von 124,5 x 124,5 mm einen Lichtstrom von 120 lumen weißes Licht liefern, was beispielsweise für eine Tischleuchte oder andere Anwendungen im Bereich von Wohnraumleuchten durchaus ausreichend ist (siehe Veröffentlichung im Internet unter http://www.lighting.philips.de/lightcommunity/trends/oled/lumibladeoledgl350.wpd.)

Bei OLED-Panels der genannten Art befindet sich in der Regel der eigentliche OLED-Stack auf einer Trägerplatte aus Glas oder Kunststoff. Wenn man ein derartiges OLED-Panel in eine Leuchte integrieren möchte, bietet es sich an, das OLED-Panel oder mehrere solcher OLED-Panels auf eine lichtdurchlässige Trägerplatte aufzubringen. Problematisch ist hierbei jedoch, dass sich bei Anlegen des OELD-Panels an die lichtdurchlässige Trägerplatte, bei der zwei plane Flächen aneinander liegen, immer eine dünne Luftschicht zwischen diesen beiden Flächen ausbildet. Diese Luftschicht erweist sich als störend, da es bei der Lichtauskopplung aus dem flächigen OLED-Panel in die flächige Trägerplatte aufgrund der zwischen dem flächigen OLED-Panel und der flächigen Trägerplatte befindlichen Luftschicht, die einen von den Trägerplatten abweichenden Brechungsindex aufweist, zu erheblichen Lichtverlusten kommt. Dieser negative Effekt besteht sowohl dann, wenn die beiden Flächen direkt aneinander gebracht werden, als auch, wenn beide Flächen beispielsweise mit einer Streuschicht durch Mattierung, Strukturierung oder Aufbringen einer Folie behandelt werden. Der Lichtverlust entsteht durch Reflexion oder Totalreflexion zwischen den beiden flächigen Elementen.

Ein Ziel im Rahmen der vorliegenden Erfindung zugrunde liegenden Entwicklung war es daher, diese Luftschicht zu verdrängen und durch eine dem Brechungsindex des flächigen Licht-Panels und der flächigen Trägerplatte möglichst gleichkommenden Brechungsindex zu ersetzen.

Grundsätzlich wäre es möglich, das Licht-Panel flächig mit der lichtdurchlässigen Trägerplatte zu verkleben, was aber technisch nicht einfach ist. Zum einen kommt es hierbei zu Lufteinschlüssen, zum anderen führt die Klebstoffschicht zwischen beiden Flächenelementen wiederum zu Lichtverlusten. Ein weiterer Nachteil liegt darin, dass eine Verklebung der Licht-Panel auf der lichtdurchlässigen Trägerplatte der Leuchte dazu führt, dass das Licht-Panel nicht mehr von der Trägerplatte der Leuchte gelöst werden kann. Zu Revisionszwecken wäre aber eine solche lösbare Verbindung vorteilhaft.

Aus der älteren, gegenüber der vorliegenden Anmeldung nicht vorveröffentlichten, Druckschrift DE 10 2012 214 478 A1 ist ein längliches Leuchtmodul mit vergossenem Leuchtband bekannt, welches einen ersten unteren Teilbereich aus einem in einer Polymermasse vergossenen LED-Band mit LEDs auf einer Leiterplatte aufweist. Auf die Oberseite dieses unteren Teilbereichs wird eine dünne Haftschicht aufgebracht. Es ist weiterhin ein zweiter Teilbereich vorgesehen, der einen diffus reflektierenden lichtdurchlässigen Körper bildet und aus einer Polymermasse, z.B. einem Silikon besteht. Als Haftvermittler für die Verbindung der beiden Teilbereiche kann ein flüssiges Silikon verwendet werden. Bei der Herstellung dieses Leuchtmoduls werden jedoch die beiden Teilbereiche erwärmt, dann wird die Haftschicht auf einen der Teilbereiche aufgebracht, dann werden beide Teilbereiche flächig miteinander verbunden und die ganze Anordnung wird erwärmt, zum Beispiel in einem Ofen. Damit wird hier eine dauerhafte stoffschlüssige Verbindung zwischen den beiden Teilbereichen hergestellt, die nicht lösbar ist. Der untere Teilbereich, in dem die LEDs vergossen sind, besteht aus einer lichtundurchlässigen Polymermasse, da die Lichtabgabe nur nach oben hin im Bereich einer Emitterfläche der Polymermasse beabsichtigt ist, so dass das Licht in den lichtdurchlässigen Körper des zweiten Teilbereichs hinein abgegeben wird.

In der DE 11 2011 104 636 T5 wird eine Licht abstrahlende Baugruppe mit einer Mehrzahl organischer elektrolumineszenter Elemente auf einem Substrat beschrieben. Diese bekannte Licht abstrahlende Vorrichtung ist sehr dünn, folienartig und flexibel und kann daher als flächiges Leuchtmittel dienen, welches auf die gekrümmte Fläche des Lampenschirms einer Leuchte aufgebracht werden oder als eine Art leuchtende Tapete an einer Wand verwendet werden kann. Im Schichtaufbau kann auch auf ein als Träger für die Folie dienendes Substrat eine Kunstharzschicht aufgebracht werden, wobei anstelle eines Kunstharzes auch eine Flüssigkeit mit einem hohen Brechungsindex verwendet werden kann. Nach dem Abscheiden wird diese Schicht jedoch durch Wärme oder Licht ausgehärtet, so dass eine stoffschlüssige Verbindung zwischen dem Substrat und den Licht abstrahlenden Schichten entsteht. Über die Schichtanordnung der Licht abstrahlenden Schichten ist deckseitig eine Versiegelungsschicht aufgebracht, um die funktionellen Schichten zu schützen. Nach der Herstellung bilden das Substrat und die auf dieses aufgebrachten Schichten eine untrennbare Einheit, die als leuchtende Folie verwendet wird und es ist weder vorgesehen noch sinnvoll eine Trennung zwischen dem Substrat (der Trägerschicht) und den funktionellen Schichten vorzunehmen, da dadurch das Produkt zerstört würde.

Die DE 20 2009 016 123 U1 beschreibt einen elektrolumineszierenden Folienverbund, bei dem ein elektrolumineszierendes Element auf einem Glas oder einer Kunststofffolie als Träger aufgebracht wird, wobei das Element mittels einer Klebstoffschicht, die dieses oberseitig bedeckt und randseitig übergreift auf dem Trägersubstrat dauerhaft befestigt wird. Über dem elektrolumineszierenden Element erstreckt sich ein Schutzfolienlaminat, das auch von der Klebstoffschicht auf dem Trägersubstrat gehalten wird. Für die Klebstoffschicht kann unter anderem ein Heißschmelzkleber verwendet werden. Ein Brechungsindex von 1,40 bis 1,52 für die Klebstoffschicht wird angegeben. Auch bei diesem bekannten Produkt handelt es sich um einen dauerhaften Folienverbund und es ist nicht vorgesehen, die Verbindung zwischen dem Trägersubstrat und dem elektrolumineszierenden Element wieder zu trennen. Vielmehr ist hier vorgesehen, dass sich die Oberseite des auf einen Untergrund aufgeklebten Folienverbunds effektiv reinigen lässt, da der Folienverbund für eine Anwendung im Außenbereich vorgesehen ist, zum Beispiel zum Bekleben von Automobilen. Es wäre daher kontraproduktiv, wenn bei der Reinigung eine Trennung zwischen Trägersubstrat und elektrolumineszierendem Element auftreten würde, denn dies würde zu einer Zerstörung der leuchtenden Folie führen.

An dieser Stelle ist anzumerken, dass es das Ziel der vorliegenden Erfindung ist, eines oder mehrere vollständige funktionsfähige flache panelartige OLED-Leuchtmittel flächig auf eine tragende Platte (Trägerplatte) einer Leuchte oder eines Displays so aufzubringen, dass das oder die OLED-Leuchtmittel zum Beispiel zu Revisionszwecken von der Trägerplatte ohne großen Aufwand abgenommen werden können. Die Trägerplatte ist also Teil der Leuchte und nicht Teil des Leuchtmittels. Hingegen geht es in dem zuvor genannten Stand der Technik um das Leuchtmittel selbst, welches einen schichtweisen Aufbau hat mit einer als Substrat dienenden Platte, auf die ein OLED-Stack aufgebracht ist, der wegen der Empfindlichkeit der OLED-Schichten gegen Sauerstoff und Feuchtigkeit nach derzeitigem Stand der Technik oberseitig immer durch eine Verkapselungsschicht abgedeckt sein muss.

Die Aufgabe der vorliegenden Erfindung besteht darin, eine Leuchte oder ein Display umfassend wenigstens ein flächig auf einer mindestens teilweise lichtdurchlässigen Trägerplatte aufliegendes Licht-Panel der eingangs genannten Gattung zur Verfügung zu stellen, bei der eine vollflächige oder zumindest teilflächige Verbindung zwischen Licht-Panel und Trägerplatte mit minimierten Lichtverlusten gegeben ist, bei gleichzeitiger Wiederlösbarkeit der Verbindung zwischen Licht-Panel und Trägerplatte.

Die Lösung der vorgenannten Aufgabe liefert eine Leuchte oder ein Display umfassend wenigstens ein flächig auf einer mindestens teilweise lichtdurchlässigen Trägerplatte aufliegendes OLED-Panel mit den Merkmalen des Anspruchs 1.

Erfindungsgemäß ist zwischen den aneinander grenzenden Flächen von OLED-Panel (hierin auch Licht-Panel genannt) und der lichtdurchlässigen Trägerplatte ein flüssiges oder dickflüssiges Haftmittel-Medium angeordnet und die Verbindung zwischen dem Licht-Panel und der Trägerplatte ist eine ohne Zerstörung oder Beeinträchtigung der Trägerplatte leicht lösbare adhäsive Verbindung. Dies ist so zu verstehen, dass man das Licht-Panel ohne großen Kraftaufwand beispielsweise von Hand oder mit einem einfachen Werkzeug von der Trägerplatte abheben und dadurch die Verbindung lösen kann. Eine vergleichsweise geringe Haftkraft, die das flüssige oder dickflüssige Haftmittel liefert, genügt, um das OLED-Lichtpanel auf der Trägerplatte in Position zu halten, da keine nennenswerten Kräfte auf die Verbindung einwirken. Dadurch ist beispielsweise bei einem Defekt des Leuchtmittels dessen einfacher Austausch möglich, indem man das Lichtpanel einfach von der Trägerplatte abhebt. Dies ist vorteilhaft im Vergleich zu einer Klebeverbindung, bei der in der Regel ein zerstörungsfreies Lösen der Verbindung nicht möglich ist bzw. in jedem Fall Rückstände des Klebstoffs an Trägerplatte und/oder Lichtpanel zurückbleiben würden. Die erfindungsgemäße Lösung ist auch vorteilhaft im Vergleich zu einer Schraubverbindung, denn es sind keine Bohrungen in der Trägerplatte erforderlich, die insbesondere das ästhetische Erscheinungsbild der Leuchte beeinträchtigen würden. Auch benötigt man keine mechanischen Befestigungselemente, die man gegebenenfalls kaschieren müsste.

Der zuvor genannte Begriff "dickflüssig" bezogen auf das Haftmittel-Medium umfasst nicht nur Flüssigkeiten mit hoher Viskosität, sondern beispielsweise auch pastöse Medien mit nur geringer Fließfähigkeit.

Aus dem Stand der Technik bekannte OLED-Panels weisen oft an der Licht abgebenden Seite eine aufgeklebte Streufolie auf, die dazu dient, den Lichtaustritt im Hinblick auf die Raumrichtungen, in die das Licht abgegeben wird, zu vergleichmäßigen. Jedoch hat sich gezeigt, dass durch Verwendung einer derartigen Streufolie auch immer ein Lichtverlust einhergeht. Die vorliegende Erfindung schlägt daher bevorzugt vor, diese Streufolie zu entfernen und die Lichtstreuung zur richtungsunabhängigen Lichtabgabe durch Streumittel zu erzielen, die sich in dem Haftmedium befinden. Hier zeigt sich ein weiterer Vorteil der erfindungsgemäßen Lösung, die die Möglichkeit bietet, das Haftmedium für diese zusätzliche Funktion zu nutzen. Bevorzugte Möglichkeiten für die Lichtstreuung durch das Haftmedium werden noch weiter unten erläutert.

Für das Haftmittel-Medium im Sinne der vorliegenden Erfindung kommt im Prinzip jedes flüssige oder dickflüssige Medium in Betracht, welches die genannten Eigenschaften im Hinblick auf den Brechungsindex erfüllt und geeignet ist eine ausreichende Adhäsion zwischen den aneinander grenzenden Flächen von Licht-Panel und lichtdurchlässiger Trägerplatte zu erzeugen, um diese dauerhaft, aber dennoch lösbar, miteinander derart zu verbinden, dass sich möglichst keine Lufteinschlüsse zwischen den aneinander grenzenden Flächen von Licht-Panel und Trägerplatte bilden.

Die erfindungsgemäße Lösung kombiniert mehrere Vorteile. Erstens wird eine Haftverbindung zwischen dem Licht-Panel und der lichtdurchlässigen Trägerplatte geschaffen, die es ermöglicht, beide Bauelemente flächig miteinander zu verbinden, ohne dass es dabei zu störenden Lufteinschlüssen kommt, die unter anderem die Lichtausbeute reduzieren und das optische Erscheinungsbild negativ beeinflussen würden. Zweitens ist diese Verbindung zwischen den beiden Bauelementen im Bedarfsfall sehr leicht wieder lösbar, so dass man zum Beispiel zu Revisionszwecken, beispielsweise im Falle einer Funktionsstörung des Licht-Panels, das Licht-Panel problemlos von der Trägerplatte lösen und austauschen kann. Dritter Vorteil ist, dass dieser Austausch von jedermann ohne großen Aufwand vorgenommen werden kann und somit die Einrichtung nicht zum Hersteller rückversandt werden muss. Vierter wesentlicher Vorteil ist, dass die störenden Reflexionen und Totalreflexionen des Lichts zwischen den flächigen Elementen aufgehoben bzw. minimiert werden.

Bevorzugt weist das Haftmittel einen von Quarzglas nur geringfügig abweichenden Brechungsindex auf, insbesondere einen Brechungsindex im Bereich von etwa 1,3 bis etwa 1,6. In der vorliegenden Anmeldung werden nachfolgend beispielsweise flüssige Haftmittel-Medien genannt, deren Brechungsindizes in dem vorgenannten Bereich liegen, insbesondere in einem für die Erfindung besonders günstigen Bereich von etwa 1,40 bis etwa 1,52. Versuche im Rahmen der Entwicklung des Erfindungsgegenstands haben gezeigt, dass bei Verwendung eines Mediums, das einen dem Material der Trägerplatte und demjenigen der untersten Schicht des Licht-Panels (in den meisten Fällen Glas) sehr ähnlichen Brechungsindex aufweist, das abgestrahlte Licht in den Grenzflächenbereichen von Licht-Panel und Trägerplatte weitgehend ungehindert durchtritt. Ganz anders ist dies bei Lufteinschlüssen, die bei den vorbekannten Lösungen auftreten, da der Brechungsindex von Luft um etwa 45 % geringer ist als derjenige von Glas.

Bevorzugt ist es gemäß einer Weiterbildung der Erfindung so, dass man als Haftmittel-Medium eine weitgehend farblose und/oder klare Flüssigkeit mit einer ölähnlichen Viskosität verwendet, wobei insbesondere die dynamische Viskosität bei Umgebungstemperatur von etwa 50 bis etwa 10⁵ mPas liegen kann.

Weiterhin ist es möglich, das Haftmittel-Medium vor oder während der Kontaktierung der beiden Flächen temporär zu erhitzen, um die Fließfähigkeit kurzzeitig zu erhöhen, um dann später, z.B. bei Umgebungstemperatur, eine höhere Viskosität des Haftmittel-Mediums zu erhalten.

Weiterhin ist es möglich, dem Medium Materialien wie zum Beispiel Streupartikel und/oder Leuchtstoffe und/oder Pigmente oder ähnliches hinzuzufügen, um zum Beispiel das Licht zu beeinflussen oder die Eigenschaften des Haftmittel-Mediums beispielsweise im Hinblick auf Viskosität, Alterungsbeständigkeit, UV-Beständigkeit oder ähnliches zu beeinflussen. Weiterhin kann dieses Haftmittel-medium als elektrischer Isolator zwischen den beiden Flächen genutzt werden.

Beispielsweise kommen gemäß einer bevorzugten Weiterbildung der Erfindung als Haftmittel-Medium organische Materialien in Betracht, insbesondere solche ausgewählt aus der Gruppe umfassend Alkohole, mehrwertige Alkohole, Kohlenwasserstoffe, Kohlenwasserstoffgemische, Öle, Fette, Ketone, Aldehyde und Ester sowie Gemische daraus. Die genannten organischen Materialien sollten dabei neben einem ähnlichen Brechungsindex wie Glas die Eigenschaft haben, dass sie das hindurchtretende Licht nur minimal absorbieren oder dispergieren und sie sollten sich gegenüber dem Material der Trägerplatte und demjenigen des Licht-Panels chemisch neutral verhalten und sich auch durch Temperatur-Einflüsse in der Haftmittelschicht zwischen den beiden Bauteilen nicht in ihren optischen Eigenschaften negativ verändern.

Besonders bevorzugt ist es, dass das Haftmittel-Medium eine organische Flüssigkeit oder eine viskose organische Substanz ausgewählt aus der Gruppe dünnflüssiges Paraffin, dickflüssiges Paraffin, Vaseline, Petroleum, Glycerin, Glykol, Cyclohexanon, Silikonöl, Siloxane sowie Gemische daraus enthält. Weiterhin kommen beispielsweise Naturöle, wie z.B. Pflanzenöle in Betracht.

Alternativ kommen auch ionische Flüssigkeiten für das Haftmittel-Medium in Betracht, das sind Salze, die bei Temperaturen von beispielsweise unter 100 °C flüssig sind, ohne dass das Salz in einem Lösungsmittel wie Wasser gelöst ist. Dies sind beispielsweise organische Salze mit alkylierten Kationen. Diese ionischen Flüssigkeiten verdampfen nicht, haben eine hohe Wärmeleitfähigkeit und sind dauerhaft stabil.

Vorzugsweise besteht mindestens die dem Licht-Panel zugewandte und mit diesem lösbar zu verbindende (gegebenenfalls beschichtete) Fläche der lichtdurchlässigen Trägerplatte aus Glas oder Kunststoffglas, insbesondere Acrylglas und ebenso besteht vorzugsweise eine der lichtdurchlässigen Trägerplatte zugewandte und mit dieser lösbar zu verbindende Trägerschicht des Licht-Panels aus gegebenenfalls beschichtetem Glas oder Kunststoffglas, insbesondere Acrylglas.

Alternativ kann man auch eine Trägerplatte verwenden, die selbst bereits Streueigenschaften aufweist, beispielsweise kommen hier Materialien wie hoch streuendes Acrylglas in Betracht oder keramische Materialien, beispielsweise Trägerplatten mit Glaskugeln oder Silikatkristallen in lichtdurchlässiger oder transparenter keramischer Farbe. Auch die Verwendung von Trägerplatten aus geätzten Gläsern, die eine hohe Lichtstreuung bewirken kommt in Betracht.

Eine alternative Lösungsvariante der vorliegenden Erfindung, die Gegenstand des Anspruchs 9 ist, sieht vor, dass das Haftmittel-Medium gallertartig oder gelartig ist, wobei zum Beispiel auch eine Gelfolie verwendet werden kann. Als Haftmittel-Medium kommt somit auch ein viskoelastisches Fluid in Frage. Wird eine Gelfolie verwendet, sollte es sich um eine nicht klebende Gelfolie handeln, damit die Wiederlösbarkeit der Verbindung zwischen Trägerplatte und OLED-Panel im Sinne der Erfindung gegeben ist. Hier kommen beispielsweise Silikongele wie z.B. auf Basis von Polydimethylsiloxan (PDMS) in Betracht, aber auch Gele oder Gelfolien anderer chemischer Zusammensetzung, zum Beispiel solche mit Agar als Hauptbestandteil, solche auf Basis von Zelluloseethern und Wasser, Silikagele oder Kieselgele, beispielsweise hergestellt aus Wasserglas, Gele oder Gelfolien aus modifizierten Polyimiden oder dergleichen.

Es kann bei dieser Variante so sein, dass beispielsweise ein Silikongel auf das OLED-Panel aufgebracht wird, dann aushärtet und dann dieses OLED-Panel mit der Seite der Gelschicht auf die Trägerplatte aufgelegt wird. Es kann dann vorkommen, dass das OLED-Panel später nicht mehr ohne weiteres von dem Haftmittel-Medium getrennt werden kann, was aber kein Nachteil wäre, da im Falle einer Revision davon auszugehen ist, dass das OLED-Panel defekt ist. Dennoch ist aber auch hier später die Verbindung zwischen dem Haftmittel-Medium und der Trägerplatte problemlos lösbar, so dass das OLED-Panel ohne Beeinträchtigung der Trägerplatte ausgetauscht werden kann.

Gele wie beispielsweise Silikongele eignen sich sehr gut für die Aufnahme von Steupartikeln, da diese in einer Polymermatrix fixiert werden und ein Absinken (ungleichmäßige Verteilung) der Streupartikel im Haftmittel-Medium verhindert wird. Die gewünschten Eigenschaften wie zum Beispiel diffuse Streuung oder Transmission können durch Auswahl der geeigneten Größe und Konzentration der Streupartikel eingestellt werden. In diesen Anwendungsfällen kommen beispielsweise Konzentrationen von etwa 0,5 Gew.% bis etwa 10 Gew.% Streupartikel im Gel in Betracht.

Als Streupartikel können zum Beispiel Mikrohohlkugeln aus Glas mit Durchmessern im Bereich von etwa 10 µm bis etwa 120 µm verwendet werden oder Silikatkristalle, die das von den OLED-Panels abgegebene Licht sehr gleichmäßig verteilen, ohne dass nennenswerte Lichtverluste auftreten.

Silikonöle und Silikongele als Haftmittelmedium haben jeweils den Vorteil, dass sie ungiftig, physiologisch unbedenklich, geruchlos, chemisch inert, temperaturstabil im Bereich von etwa -60 °C bis etwa 300°C, UV-stabil, hydrophob, nicht flüchtig und elektrisch isolierend sind und Brechungsindizes im Bereich von etwa 1,4 haben.

Gemäß einer bevorzugten Weiterbildung der erfindungsgemäßen Aufgabenlösung ist die lichtdurchlässige Trägerplatte, auf der ein oder mehrere Licht-Panels angebracht werden, Teil einer Beleuchtungseinrichtung, wie z.B. einer Außenleuchte oder einer Innenleuchte, insbesondere einer Pendelleuchte, Hängeleuchte, Deckenanbauleuchte, Deckeneinbauleuchte, Stehleuchte oder Tischleuchte. Weiterhin kommen in Betracht beispielsweise Leuchtregale, Leuchtpanels, Möbelteile, Fassadenelemente, Wandelemente, Deckenelemente; Außenleuchten, Innenleuchten oder Einbauvorrichtungen in Kraftfahrzeugen, Schienenfahrzeugen, Schiffen, Flugzeugen oder dergleichen. Dabei sind bevorzugt ein oder mehrere Licht-Panels auf der Oberseite einer mindestens teilweise lichtdurchlässigen Trägerplatte einer solchen Leuchte angeordnet.

Eine Beleuchtungseinrichtung gemäß der vorliegenden Erfindung kann z.B. sein: eine Außenleuchte oder Innenleuchte, insbesondere Pendelleuchte, Hängeleuchte, Deckenanbauleuchte, Deckeneinbauleuchte, Stehleuchte oder Tischleuchte, ein Leuchtregal, Leuchtpanel, Möbelteil, Stadtraummöbel, Fassadenelement, Wandelement, Deckenelement, eine Einbauvorrichtung im Wohnbereich, im Bürobereich, in Kraftfahrzeugen, Schienenfahrzeugen, Schiffen, Flugzeugen oder dergleichen, mit den zuvor beschriebenen Merkmalen.

Gegenstand der vorliegenden Erfindung ist weiterhin eine Displayeinrichtung (Bildschirmfunktion) zur Wiedergabe stehender oder bewegter Bilder, wie z.B. Fotos, Filme, Videos, Werbung, wie beispielsweise an einem Mobiltelefon, an einem Monitor, Bildschirm, Fernsehgerät, Kameradisplay oder ähnliches, umfassend ein zwischen einer Trägerplatte und mindestens einem OLED-Panel angeordnetes Haftmittel-Medium mit den zuvor beschriebenen Merkmalen, wobei diese Displayeinrichtung auch Teil eines Möbels, Stadtraummöbels, Fassadenelements, Deckenelements, Wandelements, einer Einbauvorrichtung im Wohnraumbereich oder in Büros, oder Teil eines Kraftfahrzeugs, Schienenfahrzeugs, Schiffs, Flugzeugs oder dergleichen sein kann.

Gegenstand der vorliegenden Erfindung kann auch beispielsweise eine Kombination von einer oder mehreren Licht abgebenden Flächen (Beleuchtungsflächen) mit einer oder mehreren Displayflächen sein.

Weiterhin ist es möglich, das Licht-Panel z.B. wenigstens teilweise mit einer Streuschicht, z.B. durch aufbringen einer Folie zu versehen, oder durch Behandlung der Oberfläche, bevor das Haftmittel-Medium zur Verbindung der beiden Flächen eingesetzt wird.

Die Trägerplatte, auf die das Licht-Panel aufgebracht wird, kann gegebenenfalls auch aus einem flexiblen Trägermaterial sein, zum Beispiel aus einem biegsamen Glas oder Kunststoff.

Die Trägerplatte einer erfindungsgemäßen Leuchte hat bevorzugt mindestens eine Fläche mit den Abmessungen eines derzeit am Markt erhältlichen OLED-Panels von beispielsweise etwa 120 mm x 120 mm, wenn es sich um ein rechteckiges OLED-Lichtpanel handelt. Dabei kann die Trägerplatte auch im Umriss rund sein oder andere Umrissformen haben, die von derjenigen des OLED-Panels abweichen. Weiterhin ist die Trägerplatte bevorzugt eine tragende Platte der Leuchte oder des Displays und sie ist nicht Teil des Leuchtmittels. Somit kann man an der Trägerplatte beispielsweise eine Aufhängung der Leuchte anbringen, wenn es sich um eine Pendelleuchte handelt oder eine Standvorrichtung, wenn es sich um eine Stehlleuchte oder Tischleuchte handelt oder eine Halterung für die Wand- oder Deckenbefestigung, wenn es sich um eine Wand- oder Deckenleuchte handelt.

Bei vertikaler oder geneigter Ausrichtung der Trägerplatte, beispielsweise bei Wandleuchten muss das Haftmittel-Medium so gewählt werden, dass dessen Adhäsionskraft groß genug ist, um das oder die OLED-Panel(s) an der Trägerplatte in Position zu halten. Die Gewichtskraft aus dem Eigengewicht des OLED-Panels muss somit kompensiert werden. Außerdem muss bei diesen Anwendungen die Konsistenz des Haftmittel-Mediums so hochviskos gewählt sein, dass gewährleistet ist, dass das Haftmittel-Medium nicht ungewollt aus dem Verbindungsbereich zwischen Trägerplatte und OLED-Panel austritt.

Werden zwei oder mehrere Lichtpanels auf der Trägerplatte in der erfindungsgemäßen Weise angebracht, dann weist die Trägerplatte bevorzugt entsprechende Abmessungen auf, so dass man mehrere Lichtpanels auf einer der Flächen der gleichen Trägerplatte haftend aufbringen kann. Beispielsweise können gemäß einer bevorzugten Weiterbildung der vorliegenden Erfindung mehrere Licht-Panels in einer oder mehreren Reihen auf einer Seite einer mindestens teilweise lichtdurchlässigen Trägerplatte angeordnet werden.

Bei einer Deckenleuchte oder Pendelleuchte bringt man die Lichtpanels vorzugsweise auf der Oberseite der Trägerplatte an, so dass die Lichtpanels durch die Trägerplatte hindurch nach unten hin abstrahlen. Bei einer Wandleuchte erfolgt bevorzugt die Anbringung der Lichtpanels entsprechend an der Rückseite der Trägerplatte, so dass auch hier das Licht durch die Trägerplatte hindurch abgestrahlt wird. Diese Variante hat den zusätzlichen Vorteil, dass man zum einen die Lichtabstrahlung auch durch optische Mittel im Bereich der Trägerplatte beeinflussen kann (zum Beispiel Lichtstreuung oder Vergleichmäßigung der flächigen Lichtabgabe, insbesondere bei mehreren Lichtpanels) und man kann auch die Trägerplatte durch Bedrucken, Beschichten, Bekleben, Ätzen, Sandstrahlen oder durch Einschlüsse in der Trägerplatte oder andere geeignete Methoden so Bearbeiten, dass auch Befestigungselemente, elektronische Bauteile, elektrische Komponenten, die sich an der der Licht abstrahlenden Seite abgewandten Rückseite der Trägerplatte befinden, an der Licht abstrahlenden Sichtseite nicht oder kaum erkennbar sind, wodurch der ästhetische Gesamteindruck der Leuchte weiter verbessert wird.

Eine besonders bevorzugte Variante der vorliegenden Erfindung sieht vor, dass man eine zweite Platte, die hierin als Deckplatte bezeichnet wird, verwendet, um die Lichtpanels zu kontaktieren. Um Lichtverluste zu vermeiden, ist es wichtig, dass die Lichtpanels mit möglichst geringem Abstand auf einer Seite der Trägerplatte aufliegen. Diese Auflagefläche ist in der Regel die Fläche an der der Licht abgebenden Fläche abgewandten Seite der Trägerplatte, so dass das Licht durch die Trägerplatte hindurch abgegeben wird. Vorteilhaft ist es, wenn die Lichtpanels so auf der Trägerplatte liegen, dass sich deren Kontakte an der der Licht abgebenden Fläche abgewandten Seite der Trägerplatte liegen, d.h. dass die Kontakte nicht zur Trägerplatte hin zeigen. Bei dieser vorteilhaften Variante kann man daher diese Kontakte der Lichtpanels über die Deckplatte kontaktieren. Dies bedeutet, die Lichtpanels liegen dann sandwichartig zwischen der Trägerplatte und der Deckplatte. An der den Lichtpanels zugewandten Seite der Deckplatte können für diese Kontaktierung beispielsweise Kontaktelemente oder Leiterbahnen oder dergleichen vorgesehen sein.

Gemäß einer bevorzugten Weiterbildung der Erfindung sind in dem Haftmittel-Medium dispergierte Streupartikel enthalten, die eine optische Streuung von durch die Anordnung hindurchtretendem Licht bewirken. Der Vorteil von dispergierten Streupartikeln im Haftmedium verglichen mit der Verwendung einer Streufolie, wie sie aus dem Stand der Technik bekannt ist, liegt darin, dass eine solche Streufolie in der Regel auf eine Trägerplatte, beispielsweise eine Licht emittierende Glasplatte, flächig aufgeklebt wird. Zum einen ist dadurch ein wieder Lösen einer solchen Verbindung nicht mehr möglich. Außerdem wurde im Rahmen von Versuchen im Zusammenhang mit der vorliegenden Erfindung festgestellt, dass ein flüssiges oder dickflüssiges Haftmittelmedium eine bessere Wärmeableitung ermöglicht, verglichen mit einer aufgeklebten Streufolie. Hier können sich beispielsweise Temperaturunterschiede von ca. 10 ° bis 15 °C im Vergleich zur herkömmlichen Lösung ergeben. Da OLED-Leuchtmittel in der Regel wärmeempfindlich sind, führt diese bessere Wärmeableitung zu einer erhöhten Lebensdauer des OLED-Leuchtmittels.

Beispielsweise kommen als Streupartikel Magnesiumoxid, Zinkoxid, Titandioxid, Glasfritten, Aluminiumstearat oder andere weiße oder farbige Materialien in Betracht, die bevorzugt in kleinen Partikeln mit einer Partikelgröße von beispielsweise weniger als 1 mm, zum Beispiel im Bereich von etwa 10 nm bis etwa 120 µm vorliegen.

Die Schichtdicke der Haftmittelschicht variiert stark in Abhängigkeit von dem Haftmittel-Medium, der Art und Größe der verwendeten OLED-Panels, dem Anwendungsbereich und dem Leuchtentyp. Beispielsweise können für das Haftmittel-Medium Schichtdicken im Bereich von weniger als einem mm, insbesondere etwa im Bereich von etwa 100 µm bis etwa 300 µm oder bis etwa 500 µm gewählt werden.

Gemäß einer weiteren bevorzugten Variante der Erfindung ist in dem Haftmittel-Medium ein Farbmittel enthalten.

Eine mögliche bevorzugte Weiterbildung der erfindungsgemäßen Aufgabenlösung kombiniert beide Lösungsalternativen, d.h. das Haftmittelmedium enthält sowohl Streupartikel als auch ein Farbmittel.

Das Farbmittel in dem Haftmittel-Medium kann beispielsweise dispergierte Farbpartikel, insbesondere Farbpigmente, umfassen oder beispielsweise mindestens einen in dem Haftmittel-Medium gelösten Farbstoff. Auf diese Weise lässt sich die Lichtfarbe des von dem Licht-Panel abgestrahlten Lichts im Vergleich zu der ursprünglichen Lichtfarbe des verwendeten Leuchtmittels verändern.

Die in den Unteransprüchen genannten Merkmale beziehen sich auf bevorzugte Ausführungsformen der Erfindung. Weitere Vorteile der Erfindung ergeben sich aus der nachfolgenden Detailbeschreibung.

Nachfolgend wird die vorliegende Erfindung anhand von Ausführungsbeispielen unter Bezugnahme auf die beiliegenden Zeichnungen näher erläutert. Dabei zeigen:
Figur 1 eine schematische perspektivische Ansicht einer beispielhaften erfindungsgemäßen Leuchte vor der Aufbringung eines OLED-Panels auf eine Trägerplatte;
Figur 2 eine schematisch vereinfachte Schnittdarstellung einer beispielhaften erfindungsgemäßen Anordnung mit auf einer Trägerplatte aufgebrachtem OLED-Panel;
Figur 3 eine schematische perspektivische Explosionsansicht einer Leuchte gemäß einer beispielhaften Variante der vorliegenden Erfindung;
Figur 4 eine schematisch vereinfachte Schnittansicht durch eine Leuchte gemäß der Variante von Figur 3, wobei ein Ausschnitt aus dieser Ansicht in einem vergrößertem Maßstab dargestellt ist;
Figur 5 eine schematisch vereinfachte Explosionsdarstellung einer Leuchte gemäß einer weiteren Variante der vorliegenden Erfindung.

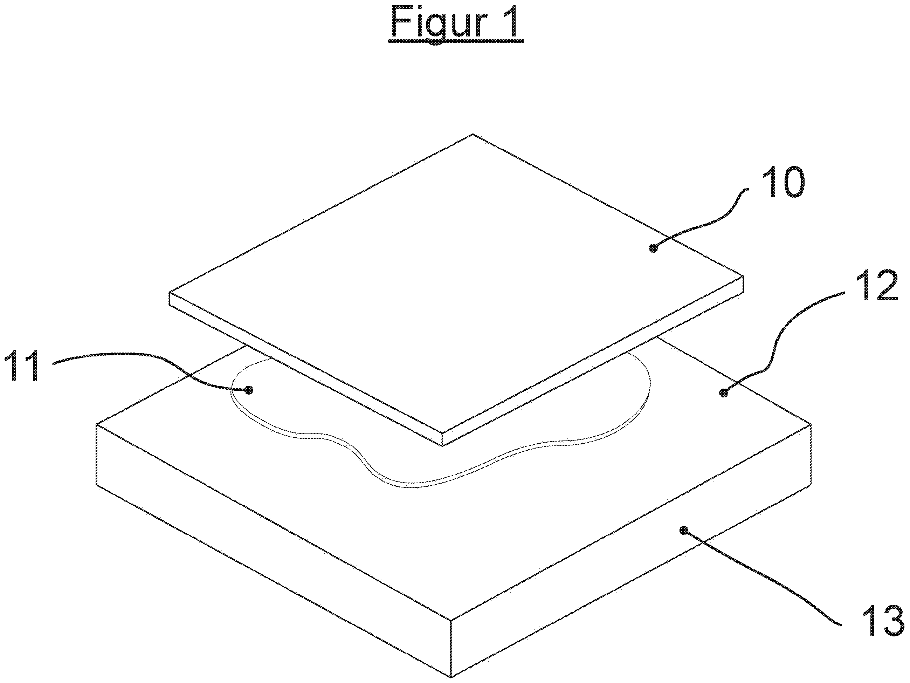

Es wird zunächst auf die Figur 1 Bezug genommen, die in perspektivischer Ansicht und stark schematisch vereinfacht ein OLED-Panel 10 zeigt, welches mittels eines Haftmittelmediums 11 auf einer Fläche 12 eines Trägerplatte 13, welches beispielsweise aus Glas oder Kunststoff besteht, flächig aufgebracht wird. Als Haftmittel-Medium 11 kommt beispielsweise ein viskose ölartige Flüssigkeit in Betracht, die einen ähnlichen Brechungsindex aufweist wie das Glas oder Kunststoffmaterial der Trägerplatte 13. Bei der Aufbringung des OLED-Panels 10 wird einfach eine geeignete Menge des Haftmittel-Mediums auf die dem OLED-Panel 10 zugewandte Fläche 12 aufgebracht und im Bereich der zu verbindenden Flächen verteilt und danach wird das OLED-Panel 10 in der vorgesehenen Position auf die Fläche 12 der Trägerplatte 13 aufgelegt, derart, dass die gesamte einander zugewandte Verbindungfläche der beiden Platten (OLED-Panel und Trägerplatte) mit dem Haftmittel-Medium benetzt ist und somit keine Lufteinschlüsse im Grenzflächenbereich mit eingeschlossen werden. Danach haftet das OLED-Panel durch die Adhäsionskraft des Haftmittel-Mediums 11 auf der Trägerplatte 13.

Um eine genaue gegenseitige Fixierung beider Platten zu sichern, ist in der Regel eine zusätzliche mechanische Verbindung, beispielsweise über eine lösbare Klemmverbindung sinnvoll, wodurch verhindert wird, dass sich das OLED-Panel verschiebt. Die hierzu verwendeten Befestigungselemente/Klemmelemente sind in der Figur 1 nicht dargestellt.

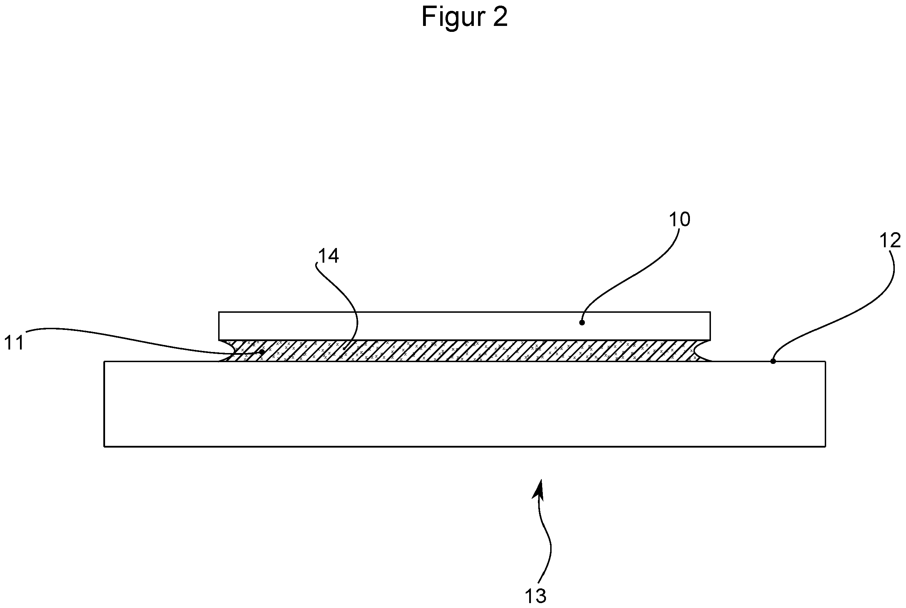

Figur 2 zeigt im schematisch vereinfachten Schnitt ein OLED-Panel 10, welches mittels des Haftmittel-Mediums 11 flächig auf der oberseitigen Fläche 12 einer Trägerplatte 13 aufgebracht ist. Die erfindungsgemäße Verbindung über das Haftmittel-Medium ist jederzeit problemlos in der Regel ohne Zuhilfenahme eines Werkzeugs möglich, indem-gegebenenfalls nach Lösen von Klemmelementen oder anderer Befestigungselemente-einfach das OLED-Panel 10 nach oben hin von der Trägerplatte 13 abgehoben wird. Beispielsweise nach einer Wartung und gegebenenfalls Reinigung der Oberfläche 12 der Trägerplatte 13 kann das OLED-Panel 10 mit neuem Haftmittel-Medium 11 erneut auf die Trägerplatte 13 aufgebracht werden.

Wie man in Figur 2 erkennen kann, wird bei dieser Ausführungsvariante das Licht (bei einer Beleuchtungsvorrichtung) oder werden die Bildelemente (im Falle eines OLED-Displays) in Richtung der Pfeile von dem OLED-Panel durch die Trägerplatte 13 hindurch abgegeben, so dass der Betrachter die dem OLED-Panel gegenüberliegende Oberfläche (in der Zeichnung Figur 2 die Unterseite) der Trägerplatte 13 betrachtet.

In dem Haftmittel-Medium sind dispergierte Streupartikel 14 enthalten, die eine optische Streuung von durch die Anordnung hindurchtretendem Licht bewirken.

Gemäß einer Variante der vorliegenden Erfindung kann man alternativ oder auch zusätzlich zu den Streupartikeln 14 dem Haftmittel-Medium 11 ein Farbmittel, beispielsweise dispergierte Pigmente oder einen im Haftmittel-Medium löslichen Farbstoff zusetzen, um auf diese Weise die Lichtfarbe des von dem OLED-Panel 10 abgegebenen Lichts zu verändern.

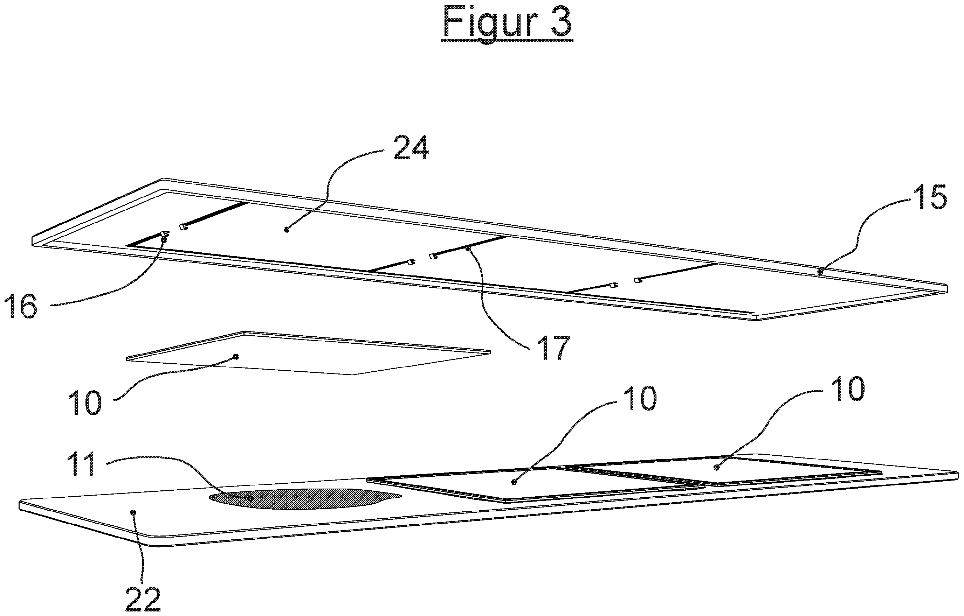

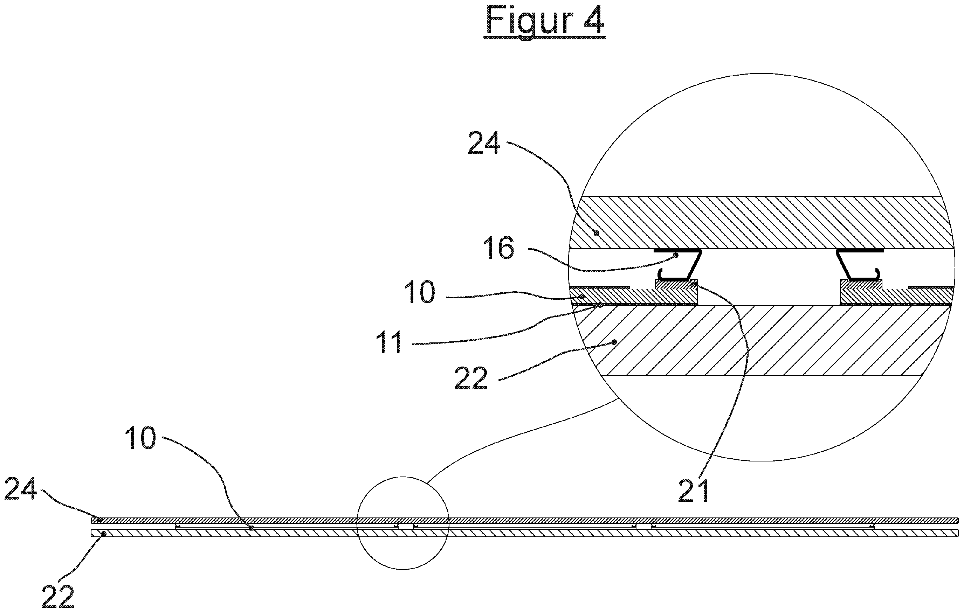

Nachfolgend wird unter Bezugnahme auf die Figuren 3 und 4 eine beispielhafte alternative Variante einer erfindungsgemäßen Leuchte erläutert. In diesem Beispiel handelt es sich um eine Pendelleuchte, bei der auf eine beispielsweise langgestreckte rechteckige Trägerplatte 22, die beispielsweise aus Glas oder Kunststoffglas besteht, mehrere OLED-Panels 10 mit ebenfalls etwa rechteckigem Grundriss aufgebracht werden. In dem Beispiel sind es drei solcher OLED-Panels 10, aber die Anzahl ist im Prinzip beliebig. Die OLED-Panels 10 können wie hier in einer Reihe oder auch beispielsweise in mehreren nebeneinander liegenden Reihen auf der Trägerplatte 22 angeordnet werden. Hier liegen die OLED-Panels 10 in Längsrichtung in einer Reihe hintereinander. Die Abmessungen der Trägerplatte 22 in Längsrichtung sind so gewählt, dass mehrere rechteckige OLED-Panels auf eine Trägerplatte 22 passen.

Da die Trägerplatte 22 in diesem Beispiel Teil einer Pendelleuchte ist, verläuft im Gebrauchszustand die Trägerplatte horizontal, so dass man das Haftmittel-Medium 11 auf die Oberseite der Trägerplatte 22 aufbringen und anschließend die OLED-Panels 10 einfach auf die mit dem Haftmittel-Medium versehenen Bereiche der Trägerplatte 22 auflegen kann. Das Haftmittel-Medium kann in einer dünnen Schicht aufgebracht werden und verteilt sich durch das Eigengewicht des OLED-Panels 10 gleichmäßig zwischen den aneinander grenzenden Oberflächen von Trägerplatte 22 und OLED-Panel 10. Dabei werden Lufteinschlüsse zwischen Trägerplatte und OLED-Panel vermieden. Es entsteht eine Haftverbindung, die sich bei Bedarf auf einfache Weise lösen lässt, indem man das OLED-Panel 10 von der Trägerplatte 22 abhebt. Das Kontaktieren der OLED-Panels 11 kann in dem Ausführungsbeispiel von Figur 3 über eine Deckplatte 24 geschehen, die beispielsweise ähnliche Abmessungen aufweisen kann wie die Trägerplatte 22 und an der sich federnde Kontakte 16 befinden, zu denen der elektrische Strom über Leiterbahnen 17 geleitet wird. Diese federnden Kontakte 16 an der Unterseite der Deckplatte 24 liegen so, dass sie beim Auflegen der Deckplatte 24 die Kontakte der OLED-Panels kontaktieren.

Dies kann man in der Detailansicht gemäß Figur 4, die einen Längsschnitt durch die Leuchte von Figur 3 zeigt, recht gut erkennen. Dort ist einer der federnden Kontakte 16 an der Unterseite der Deckplatte 24 dargestellt. Die OLED-Panels 10 haben zumeist in ihrem äußeren Randbereich einen Rahmen 21 mit Kontaktflächen, über die die Kontaktierung erfolgt. Die Deckplatte 24 selbst hat einen Rahmen 15 der als Abstandhalter zwischen Trägerplatte 22 und Deckplatte 24 dienen kann. Eine Leuchte der in den Figuren 3 und 4 gezeigten Art lässt sich somit auch in ganz einfacher Weise montieren. Man kann die Trägerplatte 22 als tragendes Bauteil der Leuchte verwenden und bei einer Pendelleuchte zum Beispiel die Aufhängungen der Leuchte an der Trägerplatte 22 anbringen. Man legt die entsprechende Anzahl der benötigten OLED-Lichtpanels 10 einfach auf die Trägerplatte 22 auf, legt danach die Deckplatte 24 auf die so mit den OLED-Panels 10 bestückte Trägerplatte 22 auf, wodurch die Kontaktierung der OLED-Panels erfolgt und der Montagevorgang ist abgeschlossen. Weitere elektronische oder elektrische Bauelemente für den Betrieb der Leuchte sowie Bedienelemente und dergleichen kann man zum Beispiel im Bereich der Deckplatte unterbringen. Die Leuchte hat somit einen einfachen Aufbau, besteht aus nur wenigen Bauteilen und ist sehr flach ausgebildet, wodurch sich ein ansprechendes Design ergibt. Der einfache konstruktive Aufbau ermöglicht eine rationelle Fertigung und eine kostengünstige Montage.

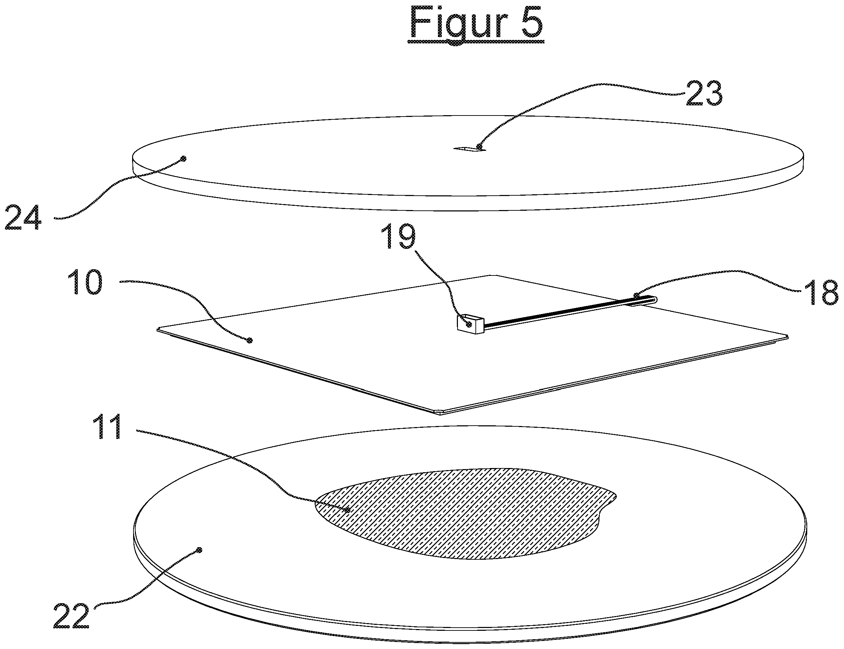

Nachfolgend wird unter Bezugnahme auf die Figur 5 ein weiteres etwas abgewandeltes Ausführungsbeispiel der vorliegenden Erfindung näher erläutert. Die Darstellung zeigt eine perspektivische Explosionsansicht und ist schematisch vereinfacht. In diesem Ausführungsbeispiel ist die Trägerplatte 22 im Umriss rund, das OLED-Panel 10 ist im Umriss rechteckig wie in den zuvor beschriebenen Beispielen, könnte aber zum Beispiel auch achteckig oder rund sein. Auch hier wird wieder auf die Trägerplatte 22 das Haftmittel-Medium 11 aufgebracht. Danach wird das OLED-Panel 10 auf die Trägerplatte 22 aufgelegt. Hier ist die Trägerplatte 22 kleiner und es wird beispielsweise nur ein OLED-Panel 10 verwendet. Auf das OLED-Panel, welches sich auf der Trägerplatte 22 befindet, wird eine im Umriss ebenfalls runde Deckplatte 24 aufgelegt. Diese Ausführungsvariante zeigt, dass nach dem gleichen Prinzip Leuchten verschiedener Typen und Größen mit unterschiedlichem Design aufgebaut werden können. Die Kontaktierung des OLED-Panels 10 erfolgt hier nicht über die Deckplatte 24, sondern es ist ein Kabel 18 vorgesehen, welches zu den Kontakten des OLED-Panels 10 führt. Die elektrische Versorgung der Leuchte kann zum Beispiel über eine mit dem Kabel 18 verbundene Steckbuchse 19 erfolgen, in die ein Stecker (hier nicht dargestellt) eingesteckt wird. Diese Steckbuchse 19 kann durch eine Aussparung 23 in der Deckplatte 24 hindurchgreifen, so dass dort bei montierter Leuchte ein elektrischer Anschluss von außen her möglich ist.

### Bezugszeichenliste

- 10: Licht-Panel, insbesondere OLED-Panel
- 11: Haftmittel-Medium
- 12: oberseitige Fläche
- 13: Trägerplatte
- 14: Streupartikel
- 15: Rahmen
- 16: Federkontakt
- 17: Leiterbahn
- 18: Kabel
- 19: Steckbuchse
- 21: Rahmen mit Kontaktflächen
- 22: Trägerplatte
- 23: Aussparung
- 24: Deckplatte

## Patentansprüche

1. Leuchte oder Display umfassend wenigstens ein flächig auf einer mindestens teilweise lichtdurchlässigen Trägerplatte (13) der Leuchte oder des Displays aufliegendes oder an dieser anliegendes Licht-Panel (10) in Form eines OLED-Leuchtmittels, **dadurch gekennzeichnet, dass** zwischen den aneinander grenzenden Flächen von Licht-Panel (10) und der lichtdurchlässigen Trägerplatte (13) ein flüssiges oder dickflüssiges Haftmittel-Medium (11) angeordnet ist und die Verbindung zwischen dem Licht-Panel (10) und der Trägerplatte (13) eine ohne Zerstörung oder Beeinträchtigung der Trägerplatte (13) leicht lösbare adhäsive Verbindung ist.

2. Leuchte oder Display nach Anspruch 1, **dadurch gekennzeichnet, dass** das Haftmittel-Medium (11) einen von Glas nur geringfügig abweichenden Brechungsindex aufweist, insbesondere einen Brechungsindex im Bereich von etwa 1,3 bis etwa 1,6.

3. Leuchte oder Display nach Anspruch 1 oder 2, **dadurch gekennzeichnet, dass** das Haftmittel-Medium (11) eine weitgehend farblose und/oder klare Flüssigkeit mit einer dynamischen Viskosität bei Umgebungstemperatur von etwa 50 bis etwa 10⁵ mPas umfasst oder ist.

4. Leuchte oder Display nach einem der Ansprüche 1 bis 3, **dadurch gekennzeichnet, dass** das Haftmittel-Medium (11) eine organische Flüssigkeit umfasst oder ist, insbesondere ausgewählt aus der Gruppe umfassend Alkohole, mehrwertige Alkohole, Kohlenwasserstoffe, Kohlenwasserstoffgemische, Öle, Fette, Ketone, Aldehyde und Ester sowie Gemische daraus.

5. Leuchte oder Display nach einem der Ansprüche 1 bis 4, **dadurch gekennzeichnet, dass** das Haftmittel-Medium (11) ein organisches Material ausgewählt aus der Gruppe dünnflüssiges Paraffin, dickflüssiges Paraffin, Vaseline, Petroleum, Glycerin, Glykol, Cyclohexanon, Silikonöl, Siloxane sowie Gemische daraus enthält oder ist.

6. Leuchte oder Display nach einem der Ansprüche 1 bis 5, **dadurch gekennzeichnet, dass** die dem Licht-Panel (10) zugewandte und mit diesem lösbar zu verbindende lichtdurchlässige Trägerplatte (13) aus gegebenenfalls beschichtetem Glas oder Kunststoffglas, insbesondere Acrylglas besteht.

7. Leuchte oder Display nach einem der Ansprüche 1 bis 6, **dadurch gekennzeichnet, dass** die der lichtdurchlässigen Trägerplatte (13) zugewandte und mit dieser lösbar zu verbindende Trägerschicht des Licht-Panels (10) aus gegebenenfalls beschichtetem Glas oder Kunststoffglas, insbesondere Acrylglas besteht.

8. Leuchte oder Display nach einem der Ansprüche 1 bis 7, **dadurch gekennzeichnet, dass** das Licht-Panel (10) eine zur Wiedergabe von stehenden oder bewegten Bildern vorgesehene Displayfläche umfasst.

9. Leuchte oder Display umfassend wenigstens ein flächig auf einer mindestens teilweise lichtdurchlässigen Trägerplatte (13) der Leuchte oder des Displays aufliegendes oder an dieser anliegendes Licht-Panel (10) in Form eines OLED-Leuchtmittels, **dadurch gekennzeichnet, dass** zwischen den aneinander grenzenden Flächen von Licht-Panel (10) und der lichtdurchlässigen Trägerplatte (13) ein pastöses, gelartiges oder gallertartiges Haftmittel-Medium (11) angeordnet ist und die Verbindung zwischen dem Licht-Panel (10) und der Trägerplatte (13) eine ohne Zerstörung oder Beeinträchtigung des Licht-Panels (10) oder der Trägerplatte (13) leicht lösbare adhäsive Verbindung ist.

10. Leuchte oder Display nach einem der Ansprüche 1 bis 9, **dadurch gekennzeichnet, dass** diese(s) eine Außenleuchte, eine Innenleuchte, insbesondere eine Pendelleuchte, Hängeleuchte, Deckenanbauleuchte, Deckeneinbauleuchte, Stehleuchte, Wandleuchte oder Tischleuchte ist oder ein Leuchtregal oder Leuchtpanel oder Teil eines Möbels oder Stadtraummöbels oder ein Fassadenelement, Wandelement, Deckenelement, eine Außenleuchte eines Kraftfahrzeugs oder eine Einbaueinrichtung eines Kraftfahrzeugs, Schienenfahrzeugs, Schiffs oder Flugzeugs ist.

11. Leuchte oder Display nach einem der Ansprüche 1 bis 10, **dadurch gekennzeichnet, dass** mehrere Licht-Panels (10) in einer oder mehreren Reihen auf einer Seite einer mindestens teilweise lichtdurchlässigen Trägerplatte (13) angeordnet sind.

12. Leuchte oder Display nach einem der Ansprüche 1 bis 11, **dadurch gekennzeichnet, dass** in dem Haftmittel-Medium (11) dispergierte Streupartikel enthalten sind, die eine optische Streuung von durch die Anordnung hindurchtretendem Licht bewirken.

13. Leuchte oder Display nach einem der Ansprüche 1 bis 12, **dadurch gekennzeichnet, dass** in dem Haftmittel-Medium (11) ein Farbmittel enthalten ist.

14. Leuchte oder Display nach Anspruch 13, **dadurch gekennzeichnet, dass** das Farbmittel in dem Haftmittel-Medium (11) dispergierte Farbpartikel, insbesondere Farbpigmente, insbesondere Fluoreszenzpigmente umfasst.

15. Leuchte oder Display nach einem der Ansprüche 13 oder 14, **dadurch gekennzeichnet, dass** das Farbmittel mindestens einen in dem Haftmittel-Medium (11) gelösten Farbstoff umfasst.

## Claims

1. A luminaire or display comprising at least one light panel (10) in the form of an OLED illuminant which rests full-surface on, or is in contact with, an at least partially light-permeable carrier plate (13) of the luminaire or the display, **characterised in that** a liquid or viscous adhesive medium (11) is arranged between the adjoining surfaces of the light panel (10) and the light-permeable carrier plate (13) and the connection between the light panel (10) and the carrier plate (13) is an adhesive connection which is easily separable without destroying or adversely affecting the carrier plate (13).

2. The luminaire or display according to claim 1, **characterised in that** the adhesive medium (11) has a refractive index varying only slightly from that of glass, in particular a refractive index in the range of approx. 1.3 to approx. 1.6.

3. The luminaire or display according to claim 1 or 2, **characterised in that** the adhesive medium (11) comprises or is a largely colourless and/or clear liquid with a dynamic viscosity at ambient temperature of approx. 50 to approx. 10⁵ mPas.

4. The luminaire or display according to one of claims 1 to 3, **characterised in that** the adhesive medium (11) comprises or is an organic liquid selected, in particular, from the group encompassing alcohols, multivalent alcohols, hydrocarbons, hydrocarbon mixtures, oils, lubricants, ketones, aldehydes and esters as well as mixtures therefrom.

5. The luminaire or display according to one of claims 1 to 4, **characterised in that** the adhesive medium (11) contains or is an organic material selected from the group of inviscid paraffin, viscous paraffin, Vaseline, petroleum, glycerine, glycol, silicon oil, siloxanes as well as mixtures therefrom.

6. The luminaire or display according to one of claims 1 to 5, **characterised in that** the light-permeable carrier plate (13) facing the light panel (10) and to be detachably connected thereto consists of glass or plastic glass, in particular acrylic glass, which may or may not be coated.

7. The luminaire or display according to one of claims 1 to 6, **characterised in that** the carrier layer of the light panel (10) facing the light-permeable carrier plate (13) and to be detachably connected to it, consists of glass or plastic glass, in particular acrylic glass, which may or may not be coated.

8. The luminaire or display according to one of claims 1 to 7, **characterised in that** the light panel (10) comprises a display surface envisaged for the reproduction of stationary or moving images.

9. The luminaire or display comprising at least one light panel (10) in the form of an OLED illuminant which rests full-surface on, or is in contact with, an at least partially light-permeable carrier plate (13) of the luminaire or the display, **characterised in that** a paste-like or gel-like or gelatinous adhesive medium (11) is arranged between the adjoining surfaces of the light panel (10) and the light-permeable carrier plate (13), and the connection between the light panel (10) and the carrier plate (13) is an adhesive connection which is easily separable without destroying or adversely affecting the light panel (10) or the carrier plate (13).

10. The luminaire or display according to one of claims 1 to 9, **characterised in that** this may be an outdoor light, an indoor light, in particular a pendant light, a hanging light, a ceiling-mounted light, a ceiling-recessed light, a standard light, a wall light or table light or a light shelf or light panel or part of a piece of furniture or street furniture, or a fagade element, wall element, ceiling element, an exterior light of a motor vehicle or a fitting in a motor vehicle, a rail vehicle, a watercraft or aircraft.

11. The luminaire or display according to one of claims 1 to 10, **characterised in that** a number of light panels (10) are arranged in one or more rows on one side of an at least partially light-permeable carrier plate (13).

12. The luminaire or display according to one of claims 1 to 11, **characterised in that** diffuser particles are dispersed in the adhesive medium (11), which cause an optical scattering of light passing through the arrangement.

13. The luminaire or display according to one of claims 1 to 12, **characterised in that** a colourant is contained in the adhesive medium (11).

14. The luminaire or display according to claim 13, **characterised in that** the colourant in the adhesive medium (11) includes dispersed colour particles, in particular colour pigments, in particular fluorescent pigments.

15. The luminaire or display according to one of claims 13 or 14, **characterised in that** the colourant includes at least one colouring agent dissolved in the adhesive medium (11).

## Revendications

1. Eclairage ou affichage comprenant au moins un panneau lumineux (10) posé à plat sur une plaque de support (13) au moins en partie transparente de l'éclairage ou de l'affichage ou adjacent à celle-ci sous la forme d'un moyen d'éclairage à diodes électroluminescentes organiques (DELO), **caractérisé en ce qu'**entre les surfaces contigües du panneau lumineux (10) et la plaque de support (13) transparente est disposé un milieu à adhésif liquide ou visqueux (11) et l'assemblage entre le panneau lumineux (10) et la plaque de support (13) est un assemblage adhésif facilement démontable sans destruction ou nuisance de la plaque de support (13).

2. Eclairage ou affichage selon la revendication 1, **caractérisé en ce que** le milieu à adhésif (11) comporte un indice de réfraction ne s'écartant faiblement que du verre, notamment un indice de réfraction dans la gamme d'environ 1,3 à environ 1,6.

3. Eclairage ou affichage selon la revendication 1 ou 2, **caractérisé en ce que** le milieu à adhésif (11) comprend ou est un liquide largement incolore et/ou clair avec une viscosité dynamique à température ambiante d'environ 50 à environ 10⁵ mPas.

4. Eclairage ou affichage selon l'une quelconque des revendications 1 à 3, **caractérisé en ce que** le milieu à adhésif (11) comprend ou est un liquide organique, notamment sélectionné à partir du groupe comprenant les alcools, les alcools polyvalents, les hydrocarbures, les mélanges d'hydrocarbures, les huiles, les graisses, l'acétone, les aldéhydes et esters ainsi que les mélanges de ceux-ci.

5. Eclairage ou affichage selon l'une quelconque des revendications 1 à 4, **caractérisé en ce que** le milieu à adhésif (11) contient ou est un matériau organique choisi à partir du groupe de la paraffine fluide, la paraffine visqueuse, la vaseline, le pétrole, la glycérine, le glycol, la cyclohexanone, l'huile de silicone, la siloxane ainsi que des mélanges de ceux-ci.

6. Eclairage ou affichage selon l'une quelconque des revendications 1 à 5, **caractérisé en ce que** la plaque de support (13) transparente tournée vers le panneau lumineux (10) et à assembler à celui-ci de façon amovible est composée de verre le cas échéant revêtu ou de verre synthétique, notamment de verre acrylique.

7. Eclairage ou affichage selon l'une quelconque des revendications 1 à 6, **caractérisé en ce que** la couche de support du panneau lumineux(10) tournée vers la plaque de support (13) transparente et à assembler à celui-ci de façon amovible est composée de verre le cas échéant revêtu ou de verre synthétique, notamment de verre acrylique.

8. Eclairage ou affichage selon l'une quelconque des revendications 1 à 7, **caractérisé en ce que** le panneau lumineux (10) comprend une surface d'affichage prévue pour retransmettre des images fixes ou mobiles.

9. Eclairage ou affichage comprenant au moins un panneau lumineux (10) posé à plat sur une plaque de support (13) au moins en partie transparente de l'éclairage ou de l'affichage adjacent à celle-ci sous la forme d'un moyen d'éclairage à diodes électroluminescentes organiques (DELO), **caractérisé en ce qu'**entre les surfaces limitrophes du panneau lumineux (10) et la plaque de support (13) transparente est disposé un milieu à adhésif pâteux, de type gel ou gélatineux (11) et l'assemblage entre le panneau lumineux (10) et la plaque de support (13) est un assemblage adhésif facilement démontable sans destruction ou nuisance du panneau lumineux (10) ou de la plaque de support (13).

10. Eclairage ou affichage selon l'une quelconque des revendications 1 à 9, **caractérisé en ce que** celui-ci est un éclairage extérieur, un éclairage intérieur, notamment un luminaire suspendu, un lustre, un luminaire de plafond, un lampadaire, un éclairage mural ou lampe de table ou une étagère lumineuse ou panneau lumineux ou partie d'un meuble ou de mobilier urbain ou un élément de façade, élément mural, élément de plafond, un éclairage extérieur d'un véhicule ou un système intégré d'un véhicule, d'un véhicule ferroviaire, d'un bateau ou d'un avion.

11. Eclairage ou affichage selon l'une quelconque des revendication 1 à 10, **caractérisé en ce que** plusieurs panneaux d'éclairage (10) sont disposés en un ou plusieurs rangs sur un côté d'au moins une plaque de support (13) au moins en partie transparente.

12. Eclairage ou affichage selon l'une quelconque des revendications 1 à 11, **caractérisé en ce que** des particules de dispersion dispersives sont contenues dans le milieu à adhésif (11) qui produisent une dispersion optique de la lumière pénétrant à travers l'agencement.

13. Eclairage ou affichage selon l'une quelconque des revendications 1 à 12, **caractérisé en ce qu'**un colorant est contenu dans le milieu à adhésif (11).

14. Eclairage ou affichage selon la revendication 13, **caractérisé en ce que** le colorant dans le milieu à adhésif (11) comprend des particules colorées dispersives, notamment des pigments colorés, notamment des pigments fluorescents.

15. Eclairage ou affichage selon l'une quelconque des revendications 13 ou 14, **caractérisé en ce que** le colorant comprend au moins une matière colorante dissoute dans le milieu à adhésif (11).
